# DEMANDE DE BREVET EUROPEEN

(11) **EP 4 683 462 A1**
(43) Date de publication de la demande: **21.01.2026**
(21) Numéro de dépôt: 25184391.8
(22) Date de dépôt: 23.06.2025
(51) Int. Cl.: H10F 19/80, H10F 19/85, B29B 17/02, B29B 17/04, B29L 31/34, B29L 9/00

(54) **PROCÉDÉ DE DÉMANTÈLEMENT D'UN MODULE PHOTOVOLTAÏQUE**

(30) Priorité: 16.07.2024 FR 2407761
(71) Demandeur: Commissariat à l'Energie Atomique et aux Energies Alternatives, 75015 Paris (FR)
(72) Inventeur: COUSTIER, Fabrice, 38054 Grenoble cedex 09 (FR); RIVA, Roland, 38054 Grenoble cedex 09 (FR); LANDA PLIQUET, Margot, 38054 Grenoble cedex 09 (FR)
(74) Mandataire: INNOV-GROUP

(57) **Abrégé**

L'invention concerne un procédé de démantèlement d'une série de modules photovoltaïques (M_1, M_2), le procédé comportant :
- Une étape de découpe (E1) d'un échantillon (ECH_1) d'un premier module photovoltaïque (M_1) de la série, ledit échantillon comportant au moins ladite couche arrière du module photovoltaïque,
- Une étape d'analyse (E2) dudit échantillon découpé en vue de déterminer l'épaisseur et la composition de chaque strate de la couche arrière du premier module photocoltaïque,
- Une étape de détermination (E3) de paramètres d'usinage (P_U) à appliquer pour retirer chaque strate de la couche arrière (1) de chaque module photovoltaïque de la série de modules photovoltaïques en tenant compte de l'analyse effectuée sur l'échantillon.

## Description

### Domaine technique de l'invention

La présente invention se rapporte à un procédé de démantèlement, au moins partiel, d'un module photovoltaïque.

### Etat de la technique

Un module photovoltaïque comporte des cellules photovoltaïques destinées à convertir une énergie solaire en une énergie électrique.

Un tel module photovoltaïque comporte de nombreux matériaux intéressants à récupérer et à valoriser, lorsque le module est en fin de vie ou défaillant.

Classiquement, un module photovoltaïque se présente sous la forme d'un panneau composé de l'assemblage de trois couches principales superposées et fixées entre elles :
- Une première couche, dite couche arrière (appelée couramment "backsheet"), formant un premier élément de protection en face arrière ;
- Une deuxième couche, dite couche intermédiaire ; cette couche intermédiaire comporte les cellules photovoltaïques, la connectique électrique entre les cellules et une enveloppe d'encapsulation arrangée autour des cellules photovoltaïques ;
- Une troisième couche, dite couche avant, formant un deuxième élément de protection en face avant ; cette couche avant est souvent en verre ou réalisée dans un polymère transparent pour être traversée par les rayons lumineux captés ;

En vue du recyclage d'un module photovoltaïque, différentes solutions ont déjà été envisagées. Une première méthode consiste à broyer le module dans sa totalité, puis de lui faire subir divers traitements thermiques et/ou chimiques afin de séparer les matériaux qui entrent dans sa composition, comme le verre, l'argent, le cuivre, le silicium... Cette première méthode est cependant coûteuse en énergie et peu respectueuse de l'environnement.

La demande de brevet WO2019/043329A1 propose une méthode de désassemblage d'un module photovoltaïque, qui consiste à retirer chaque couche du module pour la séparer, en la découpant avec un fil abrasif. Chaque couche retirée peut ensuite être traitée de manière séparée en vue de récupérer les matériaux d'intérêt. Cette dernière méthode présente certains inconvénients. Elle nécessite plusieurs postes de traitement distincts, d'abord pour la découpe, puis pour le broyage de chaque couche retirée.

La demande de brevet EP3352227A1 et la demande de brevet US2018/133720A1 décrivent des solutions de désassemblage de module photovoltaïque.

La demande de brevet EP4159397A1 décrit pour sa part le retrait par ponçage du premier élément de protection situé en face arrière et un usinage sélectif de la couche intermédiaire, réalisé par fraisage.

Actuellement, les modules photovoltaïques qui sont amenés à être démantelés peuvent être d'origines diverses et avoir été fabriqués à différentes époques, plus ou moins lointaines. Or, la composition des modules a varié au cours du temps.

On distingue notamment des modules photovoltaïques dont :
- La couche arrière contient une strate réalisée dans un polymère fluoré et assemblée sur une strate réalisée dans un polymère non fluoré ;
- La couche arrière ne contient qu'une seule strate réalisée dans un polymère non fluoré ;
- Le polymère non fluoré peut être en Polyamide, PET ou autre matériau ;
- L'enveloppe d'encapsulation de la couche intermédiaire est réalisée dans un matériau de type EVA ou dans un autre matériau ;
- La couche avant réalisée en verre peut contenir de l'antimoine ou non ;

Selon la composition du module, le démantèlement devra être adapté afin de valoriser au mieux ses différents composants.

La publication référencée « Ke Li, Zhi Wang, Changming Liu, Dong Wang, Guobiao Li, Xuanyi Chen, Guoyu Qian, Kaibo Hu, A green method to separate different layers in photovoltaic modules by using DMPU as a separation agent, Solar Energy Materials and Solar Cells, Volume 245, 2022, 111870, ISSN 0927-0248, https://doi.org/10.1016/j.solmat.2022.111870 » décrit une méthode de séparation des différentes couches d'un module photovoltaïque en vue d'un recyclage.

La publication référencée *"*De Biasio, M, Gassner, A, Eder, GC & Neumaier, L 2024, Non-destructive thickness measurement of the individual layers of end-of-life photovoltaic modules to enable optimized layer separation. in SPIE Defense + Commercial Sensing, 2024. SPIE Commercial + Scientific Sensing and Imaging. <https://doi.org/10.1117/12.3011131*>"* propose d'utiliser un principe NIR et la tomographie pour déterminer la composition et l'épaisseur des couches d'un module photovoltaïque

Le but de l'invention est de proposer une solution de démantèlement d'un module photovoltaïque tenant compte de la composition des strates/couches du module photovoltaïque, permettant ainsi de mieux séparer les différents composés et de mieux les valoriser.

### Exposé de l'invention

Ce but est atteint par un procédé de démantèlement d'une série de modules photovoltaïques, chaque module photovoltaïque de la série de modules photovoltaïques comprenant plusieurs couches superposées composées de :
- Une première couche, dite couche arrière, formant un premier élément de protection en face arrière du module photovoltaïque, cette couche arrière étant réalisée à base d'au moins un matériau polymère,
- Une deuxième couche, dite couche intermédiaire, intercalée entre la couche arrière et une troisième couche, dite couche avant, et comprenant une enveloppe d'encapsulation dans laquelle sont placées des cellules photovoltaïques,
- La couche avant, formant un deuxième élément de protection en face avant du module photovoltaïque,
- Chaque couche pouvant comporter une ou plusieurs strates,
- Le procédé comportant :
   - Une étape de découpe d'un échantillon d'un premier module photovoltaïque de la série, ledit échantillon comportant au moins ladite couche arrière du module photovoltaïque,
   - Une étape d'analyse dudit échantillon découpé en vue de déterminer l'épaisseur et la composition de chaque strate de ladite couche arrière,
   - Une étape de détermination de paramètres d'usinage à appliquer pour retirer chaque strate de la couche arrière de chaque module photovoltaïque de la série de modules photovoltaïques en tenant compte de l'analyse effectuée sur l'échantillon.

L'invention prévoit ainsi la découpe d'un échantillon d'un module photovoltaïque d'une série de plusieurs modules pour l'analyser, en vue de la détermination de paramètres d'usinage, les paramètres d'usinage étant ensuite appliqués sur les autres modules photovoltaïques de la série. Ce principe n'est pas décrit dans les documents antérieurs cités ci-dessus.

Il faut noter que l'étape de découpe d'un échantillon et celle d'analyse peut être mené sur plusieurs modules photovoltaïques de la série, avant la détermination des paramètres d'usinage.

Selon une réalisation particulière, lorsque la couche arrière comporte une première strate, située à l'arrière du premier module photovoltaïque et réalisée à base d'un polymère fluoré, le procédé consiste à fixer les paramètres d'usinage pour retirer par usinage cette première strate uniquement.

Selon une autre réalisation particulière, lorsque la couche arrière du premier module photovoltaïque comporte une deuxième strate située entre ladite première strate et la couche intermédiaire, ladite deuxième strate étant réalisée à base d'un polymère non fluoré, le procédé consiste à fixer les paramètres d'usinage pour retirer uniquement cette deuxième strate par usinage, après le retrait par usinage de ladite première strate. Selon une autre réalisation particulière, lorsque la couche arrière comporte une première strate, située à l'arrière du premier module photovoltaïque et réalisée à base d'un polymère non fluoré, le procédé consiste à fixer les paramètres d'usinage pour retirer cette première strate uniquement par usinage.

Selon une particularité, le procédé comporte une étape d'usinage de chaque strate de la couche arrière de chaque module photovoltaïque de la série de modules photovoltaïques selon les paramètres d'usinage déterminés pour le premier module photovoltaïque.

Selon une autre particularité, l'étape d'usinage de chaque strate est mise en œuvre par ponçage.

Selon une autre particularité, le procédé comporte une étape de vérification du retrait de ladite première strate de la couche arrière.

Selon une autre particularité, l'étape de découpe consiste à prélever un échantillon du premier module photovoltaïque contenant la couche arrière et la couche intermédiaire du premier module photovoltaïque.

Selon une autre particularité
- L'étape d'analyse dudit échantillon découpé est réalisée en vue de déterminer également l'épaisseur et la composition de chaque strate de ladite couche intermédiaire,
- Les paramètres d'usinage sont également déterminés pour retirer chaque strate de la couche intermédiaire de chaque module photovoltaïque de la série de modules photovoltaïques en tenant compte de l'analyse effectuée sur l'échantillon.

Selon une autre particularité, le procédé comporte une étape d'usinage de la couche intermédiaire de chaque module photovoltaïque de la série modules photovoltaïques en tenant compte des paramètres d'usinage déterminés.

Selon une autre particularité, le procédé comporte une étape de vérification du retrait de la couche intermédiaire.

Selon une autre particularité, l'étape d'analyse est réalisée par spectroscopie infrarouge à transformée de Fourier.

Selon une autre particularité, l'étape de découpe est mise en œuvre à l'aide d'un outil de découpe contrôlé pour venir découper le premier module photovoltaïque selon un angle déterminé, incliné par rapport à la normale au plan formé par la face arrière du premier module photovoltaïque.

L'invention concerne également un système de démantèlement d'une série de modules photovoltaïques, chaque module photovoltaïque de la série de modules photovoltaïques comprenant plusieurs couches superposées composées de :
- Une première couche, dite couche arrière, formant un premier élément de protection en face arrière du module photovoltaïque, cette couche arrière étant réalisée à base d'au moins un matériau polymère,
- Une deuxième couche, dite couche intermédiaire, intercalée entre la couche arrière et une troisième couche, dite couche avant, et comprenant une enveloppe d'encapsulation dans laquelle sont placées des cellules photovoltaïques,
- La couche avant, formant un deuxième élément de protection en face avant du module photovoltaïque,
- Chaque couche pouvant comporter une ou plusieurs strates,
- Le système comportant :
   - Un poste de découpe d'un échantillon d'un premier module photovoltaïque de la série, ledit échantillon comportant au moins ladite couche arrière du module photovoltaïque,
   - Un poste d'analyse dudit échantillon découpé en vue de déterminer l'épaisseur et la composition de chaque strate de ladite couche arrière,
   - Des moyens de détermination de paramètres d'usinage à appliquer pour retirer chaque strate de la couche arrière de chaque module photovoltaïque de la série de modules photovoltaïques en tenant compte de l'analyse effectuée sur l'échantillon par le poste d'analyse.

Selon une réalisation particulière, lorsque la couche arrière comporte une première strate, située à l'arrière du premier module photovoltaïque et réalisée à base d'un polymère fluoré, les moyens de détermination sont configurés pour fixer les paramètres d'usinage pour retirer par usinage cette première strate uniquement.

Selon une autre réalisation particulière, lorsque la couche arrière du premier module photovoltaïque comporte une deuxième strate située entre ladite première strate et la couche intermédiaire, ladite deuxième strate étant réalisée à base d'un polymère non fluoré, les moyens de détermination sont configurés pour fixer les paramètres d'usinage pour retirer uniquement cette deuxième strate par usinage, après le retrait par usinage de ladite première strate.

Selon une autre réalisation particulière, lorsque la couche arrière comporte une première strate, située à l'arrière du premier module photovoltaïque et réalisée à base d'un polymère non fluoré, les moyens de détermination sont configurés pour fixer les paramètres d'usinage pour retirer cette première strate uniquement par usinage. Selon une particularité, le système comporte un poste d'usinage distinct pour usiner chaque strate de la couche arrière de chaque module photovoltaïque de la série de modules photovoltaïques selon les paramètres d'usinage déterminés.

Selon une autre particularité, chaque poste d'usinage comporte un outil de ponçage. Selon une autre particularité, le poste de découpe est contrôlé pour prélever un échantillon du premier module photovoltaïque contenant la couche arrière et la couche intermédiaire (2) du premier module photovoltaïque.

Selon une autre particularité :
- Le poste d'analyse dudit échantillon découpé est configuré pour déterminer également l'épaisseur et la composition de chaque strate de ladite couche intermédiaire,
- Les paramètres d'usinage sont également déterminés pour retirer chaque strate de la couche intermédiaire de chaque module photovoltaïque de la série de modules photovoltaïques en tenant compte de l'analyse effectuée sur l'échantillon par le poste d'analyse.

Selon une autre particularité, le système comporte un poste d'usinage de la couche intermédiaire de chaque module photovoltaïque de la série modules photovoltaïques en tenant compte des paramètres d'usinage déterminés.

Selon une autre particularité, le poste d'analyse comporte un spectroscope infrarouge à transformée de Fourier.

Selon une autre particularité, l'outil de découpe est contrôlé pour venir découper le premier module photovoltaïque selon un angle déterminé, incliné par rapport à la normale au plan formé par la face arrière du premier module photovoltaïque.

### Brève description des figures

D'autres caractéristiques et avantages vont apparaître dans la description détaillée qui suit, en liaison avec les dessins annexés listés ci-dessous :
- Les figures 1A et 1B montrent, vus en coupe transversale, deux exemples de réalisation de la structure multicouches d'un module photovoltaïque ;
- Les figures 2A et 2B illustrent le principe de réalisation du système de l'invention en corrélation avec les étapes du procédé de l'invention ;

### Description détaillée d'au moins un mode de réalisation

Dans la suite de la description, la face avant du module photovoltaïque M correspond à une face du module recevant les rayons lumineux et la face arrière correspond à la face opposée à la face avant.

Dans la suite de la description, les termes arrière et avant sont donc à considérer en prenant un axe perpendiculaire à la surface du module et orientée de sa face arrière vers sa face avant.

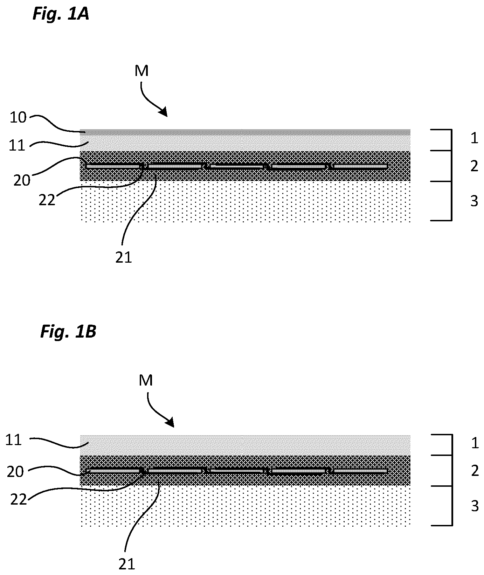

En référence à la figure 1A et à la figure 1B, de manière connue, un module photovoltaïque comporte plusieurs couches superposées et assemblées entre elles :
- Une première couche, dite couche arrière 1 (appelée couramment "backsheet"), formant un premier élément de protection en face arrière ; cette couche arrière est habituellement réalisée dans un matériau de type polymère à une ou plusieurs strates (voir ci-dessous) ;
- Une deuxième couche, dite couche intermédiaire 2, intercalée entre la couche arrière 1 et la couche avant 3 (décrite ci-dessous), permettant l'assemblage d'un côté de la couche arrière 1 et de l'autre côté de la couche avant 3 ; cette couche intermédiaire 2 comporte les cellules photovoltaïques 20, la connectique électrique 22 et une enveloppe d'encapsulation 21 arrangée autour des cellules photovoltaïques ;
- La couche avant 3, formant un deuxième élément de protection en face avant ; cette couche avant 3 est habituellement réalisée en verre ou dans un polymère transparent ;

Il faut noter que sur les figures annexées, le module photovoltaïque M est représenté retourné, de sorte que sa face arrière est située au-dessus et la face avant est située au-dessous.

Pour des soucis de lisibilité sur les figures 1A et 1B annexées, les différentes couches du module ne sont pas représentées à l'échelle. A titre d'exemple, la couche arrière 1 peut présenter une épaisseur de quelques centaines de µm (par exemple environ 350µm), la couche intermédiaire 2 peut présenter une épaisseur pouvant aller jusqu'à 1mm et la couche avant 3 peut présenter une épaisseur d'environ 3 à 4mm.

La couche arrière 1 peut notamment assurer une fonction d'imperméabilité aux gaz et à l'eau, une fonction de protection/isolation électrique et une fonction de protection mécanique.

Cette couche arrière 1 peut comporter une ou plusieurs strates distinctes.

Comme représentée sur la figure 1A, elle peut notamment comporter une première strate 10 située le plus à l'arrière, réalisée à base d'un polymère fluoré, et une deuxième strate 11 agencée devant cette première strate 10 et composée d'un polymère non fluoré. Une troisième strate (non représentée) réalisée en polymère fluoré peut également être intégrée devant la deuxième strate, en contact avec la couche intermédiaire.

Dans le cas où la couche arrière est composée d'une seule strate 11 comme sur la structure de la figure 1B, celle-ci est composée d'un polymère non fluoré.

Le polymère fluoré peut être le polyfluorure de vinyle (PVF), par exemple commercialisé sous le nom TEDLAR (marque déposée) par la société DuPont (marque déposée).

Le polymère non fluoré peut être le PET (poly(téréphtalate) d'éthylène), le polyamide ou autre.

Dans la couche intermédiaire 2, l'enveloppe d'encapsulation 21 est classiquement réalisée dans un polymère tel que de l'EVA (Ethylène-Acétate de Vinyl) formant un matériau sur lequel peuvent adhérer la couche arrière 1 d'un côté et la couche avant 3 de l'autre côté et permettre l'assemblage des trois couches entre elles. Les trois couches peuvent être assemblées entre elles par laminage à chaud, de sorte que la couche arrière 1 et la couche avant 3 viennent adhérer au matériau de l'enveloppe d'encapsulation, formant ainsi un empilement monobloc.

Dans la couche intermédiaire 2, les cellules photovoltaïques 20 sont connectées entre elles, en série/parallèle, formant plusieurs chaînes ("string" en anglais) de cellules. Des éléments de connexion électrique 22, par exemple en cuivre, permettent d'assurer les liaisons électriques entre les cellules 20 dans chaque chaîne.

Le module photovoltaïque M peut comporter un cadre (non représenté), par exemple en aluminium, agencé en périphérie de l'empilement pour rigidifier le module M. Pour la mise en œuvre de l'invention décrite ci-dessous, ce cadre, ainsi que la boîte de jonction électrique (non représentée) généralement fixée sur la face arrière du module M, sont préalablement retirés. Le procédé de l'invention est en effet dédié plus particulièrement au traitement de l'empilement de couches du module photovoltaïque M.

Le procédé de l'invention est mis en œuvre à l'aide d'un système comportant une unité de traitement chargée de contrôler la mise en œuvre des différentes étapes du procédé. Le système peut également comporter :
- Un poste de prélèvement d'un ou plusieurs échantillons par découpe localisée d'un ou plusieurs modules photovoltaïques en vue de leur caractérisation ;
- Un poste d'analyse de l'échantillon de module découpé ;
- Un ou plusieurs postes d'usinage de chaque strate/couche du module ;
- Un ou plusieurs postes de vérification de chaque usinage effectué ;
- Un poste d'analyse optique de la couche intermédiaire ;
- Un poste d'analyse de la couche avant ;

Le système peut comporter des moyens de convoyage, composés d'un ou plusieurs convoyeurs, contrôlés pour faire avancer chaque module photovoltaïque lors de son démantèlement sur chaque poste d'usinage/analyse.

L'un des principes de l'invention consiste à venir prélever un échantillon d'au moins un module photovoltaïque en vue de le caractériser, pour en déduire les paramètres d'usinage à appliquer, ces paramètres d'usinage étant adaptés pour venir retirer une ou plusieurs strates/couches des modules photovoltaïques appartenant à une même série de modules photovoltaïques.

Le prélèvement d'échantillon peut être renouvelé plusieurs fois, sur un même module photovoltaïque ou sur un ou plusieurs autres modules photovoltaïques de la série. Un échantillonnage statistique peut être mis en œuvre pour sélectionner plusieurs modules photovoltaïques d'une même série, en vue de leur caractérisation. Les paramètres d'usinage sont ensuite déterminés sur la base de l'ensemble des échantillons prélevés.

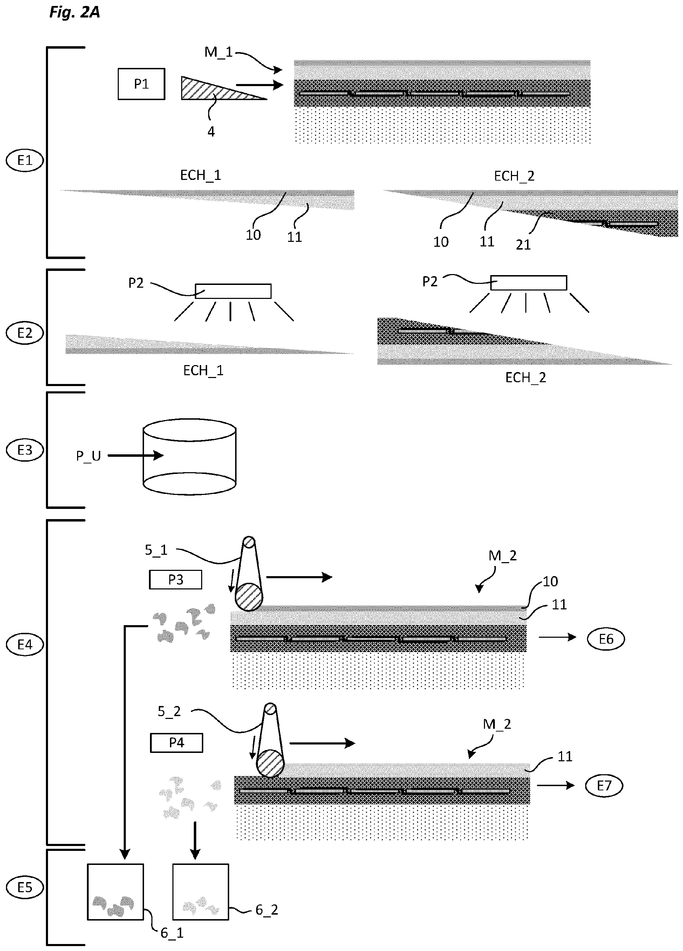

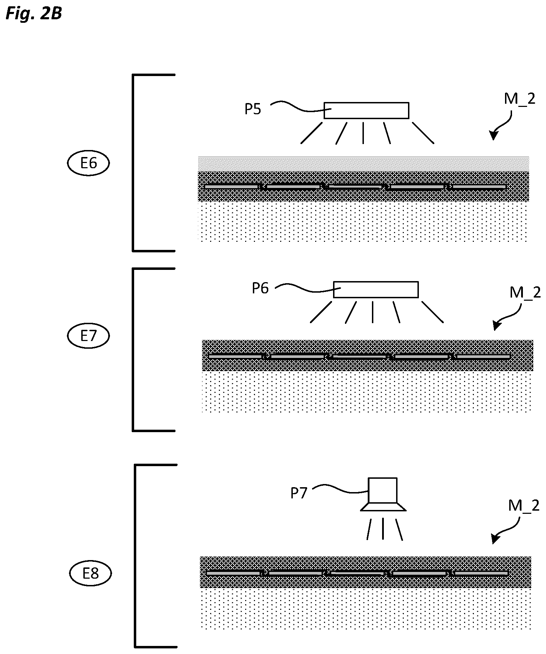

Le procédé est illustré par le diagramme de la figure 2A et de la figure 2B, à partir d'un module photovoltaïque ayant la structure multicouche représentée sur la figure 1A.

Une première étape E1 du procédé consiste à effectuer le prélèvement d'un échantillon (ECH_1 ou ECH_2 selon l'option de découpe choisie) du module photovoltaïque. Ce prélèvement consiste à venir effectuer une découpe sur un premier module photovoltaïque en amenant le module photovoltaïque M_1 sur un poste de découpe P1 du système. Ce module photovoltaïque M_1 est par exemple le premier module d'une série de modules photovoltaïques ayant tous une architecture identique ou quasi-identique.

La découpe est réalisée avantageusement à l'aide d'un outil de découpe 4 tranchant. La découpe est réalisée de manière à obtenir un échantillon ECH_1 comportant la couche arrière uniquement ou un échantillon ECH_2 comportant la couche arrière 1 et la couche intermédiaire 2 du module photovoltaïque.

La découpe peut être réalisée suivant une direction normale à la face arrière du module photovoltaïque.

De manière avantageuse, l'outil de découpe 4 est cependant incliné par rapport à la normale à la face arrière du module photovoltaïque M_1.

L'angle de découpe est par exemple compris entre 1° et 10°, préférentiellement compris entre 2° et 5°.

L'angle d'inclinaison de l'outil de découpe 4 (différent de la normale) permet d'avoir plus de précision sur les différentes épaisseurs des couches composant le module photovoltaïque. En effet, avec un angle par exemple de 3°, une épaisseur de strate à base de polymère fluoré de seulement 30 µm peut alors être visible et mesurable à la surface de l'échantillon prélevé, sur une longueur de 573 µm.

Comme représenté sur la figure 2A, on constate que l'échantillon obtenu permet de discerner les différentes strates/couches du module photovoltaïque.

Une fois la découpe réalisée, une deuxième étape E2 du procédé de l'invention consiste à venir analyser l'échantillon (ECH_1 ou ECH_2) pour déterminer la composition de chaque strate/couche du module photovoltaïque M_1.

L'analyse peut être mise en œuvre sur un poste d'analyse P2 du système, par exemple à l'aide d'un premier spectroscope infrarouge à transformée de Fourier (appelé FTIR). Il serait également possible d'employer tout autre appareil pour affiner l'analyse de la structure du module photovoltaïque.

L'analyse permet de déterminer :
- La présence ou non de composés fluorés dans chaque strate/couche du module photovoltaïque ;
- La nature du polymère non fluoré principal utilisé pour la couche arrière (c'est-à-dire PET, Polyamide ou autre) ;
- Le matériau composant l'enveloppe d'encapsulation (EVA ou autre) ;
- L'épaisseur de chaque strate/couche du module photovoltaïque (par exemple par analyse d'image) ;

Une fois l'analyse effectuée, l'unité de traitement du système dispose de données relatives à la composition et aux dimensions des couches/strates du module photovoltaïque M_1.

Lors d'une troisième étape E3, l'unité de traitement détermine les paramètres d'usinage P_U en tenant compte des données recueillies lors de l'analyse. Ces paramètres d'usinage sont amenés à être stockés dans des moyens de mémorisation associés à l'unité de traitement.

Les paramètres d'usinage P_U sont déterminés pour tenir compte de :
- La présence de composé fluoré dans la couche arrière 1 ; en présence d'une strate 10 à base de composé fluoré, cette strate devra être retirée de manière indépendante pour être séparée du reste de la couche arrière 1 ;
- Le type de polymère non fluoré utilisé dans la couche arrière 1 pour adapter le choix de l'outil d'usinage pour usiner chaque strate/couche ;
- Le type de matériau utilisé pour réaliser l'enveloppe d'encapsulation 21 de la couche intermédiaire afin d'adapter le choix de l'outil d'usinage pour usiner la couche intermédiaire 2 ;
- L'épaisseur de chaque strate/couche en vue de régler notamment la profondeur d'usinage de l'outil d'usinage sélectionné ;

Les étapes E1 à E3 peuvent être mises en œuvre sur un premier module photovoltaïque M_1 d'une série de plusieurs modules photovoltaïques identiques. Il est également possible de renouveler ces étapes une ou plusieurs fois, sur le même module photovoltaïque ou sur un ou plusieurs autres modules photovoltaïques de la série. Il est ensuite possible de déterminer les paramètres d'usinage optimaux adaptés aux différents modules photovoltaïques de la série.

Autrement dit, la détermination des paramètres d'usinage est donc avantageusement réalisée un nombre limité de fois et les paramètres d'usinage P_U déterminées sont réutilisés directement pour chaque nouveau module photovoltaïque M_2 de la série, dans la mesure où les modules photovoltaïques à traiter sont censés tous présenter une architecture identique. Réaliser plusieurs échantillons présentent notamment un intérêt, dans la mesure où les modules photovoltaïques, même au sein d'une même série, peuvent présenter des différences structurelles.

Il est notamment possible de réaliser un échantillonnage statistique en vue de sélectionner plusieurs modules d'une série, destinés à être découpés en vue de créer plusieurs échantillons à analyser.

Une fois les paramètres d'usinage P_U déterminés, dans une quatrième étape E4, l'unité de traitement est configurée pour contrôler chaque outil d'usinage 5_1, 5_2. Comme indiqué ci-dessus, selon le type de matériau employé pour chaque strate/couche, l'épaisseur de chaque strate/couche, l'outil d'usinage pourra être différent. On utilisera ainsi avantageusement plusieurs postes d'usinage P3, P4 pour venir retirer chaque strate/couche d'un module photovoltaïque M_2. Chaque poste d'usinage P3, P4 est contrôlé selon les paramètres déterminés pour le retrait de la strate/couche pour lequel il est dédié.

Les paramètres d'usinage P_U sont appliqués pour chaque module photovoltaïque M_2 de la série se présentant devant chaque poste d'usinage.

De manière avantageuse, l'outil d'usinage 5_1, 5_2 employé sur un ou plusieurs postes d'usinage peut être un outil de ponçage. L'outil de ponçage est contrôlé de manière à ce que sa bande de ponçage vienne creuser la strate/couche sur l'épaisseur déterminée. Un déplacement du module photovoltaïque et/ou de l'outil de ponçage peut être mis en œuvre pour couvrir toute la surface de la strate/couche à retirer.

Selon la strate/couche à retirer, l'outil d'usinage employé peut être un outil de fraisage (non représenté). Ce serait le cas par exemple pour venir usiner localement l'enveloppe d'encapsulation de la couche intermédiaire pour retirer la couche de matériau d'encapsulation, en évitant les zones où sont placées les cellules et les rubans d'interconnexion.

Dans une cinquième étape E5, le matériau composant chaque strate/couche usinée est récupéré dans un bac 6_1, 6_2 séparé afin d'être valorisé ultérieurement.

Le procédé peut avantageusement intégrer une ou plusieurs étapes de vérification E6, E7 du retrait de chaque strate/couche après usinage, en utilisant un ou plusieurs postes d'analyse P5, P6. Autrement dit, lorsque la couche arrière 1 ou l'une des strates de la couche arrière est retirée, le procédé consiste à scanner la surface du module photovoltaïque M_2 pour vérifier que la strate/couche a, comme prévu, bien été retirée. Cette vérification peut être mise en œuvre en plaçant un deuxième spectroscope infrarouge à transformée de Fourier en sortie, après le poste d'usinage considéré.

De manière avantageuse, une autre étape de vérification (non représentée) peut être mise en œuvre lors de chaque usinage afin de s'assurer du retrait de la strate/couche considérée, et que les paramètres d'usinage P_U déterminés sont valides et adaptés au retrait de la strate/couche considérée. Cela peut également être le cas après retrait par usinage de la couche intermédiaire 2.

Une fois la couche arrière 1 retirée, il est possible de déterminer, par exemple par analyse optique lors d'une étape E8, la structure de la couche intermédiaire 2, notamment le positionnement des cellules 20 et des éléments de connexion 22. Pour cela, un poste d'analyse optique P7 peut être agencé sur le trajet du module M_2, en aval du ou des postes d'usinage de la couche arrière.

De manière non limitative, pour la mise en œuvre du procédé de l'invention, le module photovoltaïque peut être positionné sur un convoyeur chargé de le faire avancer et de l'amener en vis-à-vis de chaque poste d'usinage lors de l'étape E4.

De manière non limitative, il faut noter que lors de la mise en œuvre de la première étape E1, le module photovoltaïque M_1 à découper est positionné en vis-à-vis du poste de découpe P1 et l'échantillon découpé est envoyé en vis-à-vis du poste d'analyse P2 pour détermination des données relatives à la composition et aux dimensions des couches/strates du module photovoltaïque. L'unité de traitement détermine ensuite les paramètres d'usinage P_U applicables à chaque autre module photovoltaïque de la série ayant une architecture identique. Comme indiqué ci-dessus, plusieurs prélèvements d'échantillons peuvent être effectués successivement, avant la détermination des paramètres d'usinage définitifs.

L'usinage de chaque strate/couche permet de récupérer les matériaux sous forme de poudre ou de copeaux (étape E5), la poudre ou les copeaux étant la plus pure possible (idéalement une poudre contenant un seul matériau - Polymère fluoré/polymère non fluoré/EVA...) dès l'instant que les paramètres d'usinage sont valides et qu'ils permettent de bien différencier les strates/couches entre elles.

De manière avantageuse, le système pourrait intégrer un poste d'analyse à rayons X (non représenté), contrôlée pour déterminer la présence ou non d'antimoine dans la couche avant 3 du module photovoltaïque. L'antimoine est un composé fréquemment utilisé pour la fabrication de verres ultra transparents. Sa présence dans le verre d'un module photovoltaïque pose des problèmes de recyclabilité. Cet autre équipement d'analyse pourrait être agencé en aval des postes d'usinage de la couche arrière et de la couche intermédiaire, afin de pouvoir scanner la couche avant du module photovoltaïque.

De manière avantageuse, il est possible de prévoir un traitement particulier de la couche intermédiaire 2, permettant de venir au préalable retirer les rubans d'interconnexion utilisés pour connecter les chaînes de cellules entre elles.

L'invention présente ainsi de nombreux avantages, parmi lesquels :
- Une solution adaptable tenant compte des différentes architectures de modules photovoltaïques ;
- Une solution permettant d'isoler les composés fluorés du reste des autres composés ;
- Une solution facilement industrialisable, utilisant notamment le principe d'usinage pour retirer les strates/couches du module photovoltaïque ;

## Revendications

1. Procédé de démantèlement d'une série de modules photovoltaïques (M_1, M_2), chaque module photovoltaïque de la série de modules photovoltaïques comprenant plusieurs couches superposées composées de :
- Une première couche, dite couche arrière (1), formant un premier élément de protection en face arrière du module photovoltaïque (M_1), cette couche arrière étant réalisée à base d'au moins un matériau polymère,
- Une deuxième couche, dite couche intermédiaire (2), intercalée entre la couche arrière (1) et une troisième couche, dite couche avant (3), et comprenant une enveloppe d'encapsulation (21) dans laquelle sont placées des cellules photovoltaïques (20),
- La couche avant (3), formant un deuxième élément de protection en face avant du module photovoltaïque (M_1),
- Chaque couche pouvant comporter une ou plusieurs strates,
- **Caractérisé en ce que** le procédé comporte :
- Une étape de découpe (E1) d'un échantillon (ECH_1) d'un premier module photovoltaïque (M_1) de la série, ledit échantillon comportant au moins ladite couche arrière du module photovoltaïque,
- Une étape d'analyse (E2) dudit échantillon découpé en vue de déterminer l'épaisseur et la composition de chaque strate de ladite couche arrière,
- Une étape de détermination (E3) de paramètres d'usinage (P_U) à appliquer pour retirer chaque strate de la couche arrière (1) de chaque module photovoltaïque de la série de modules photovoltaïques en tenant compte de l'analyse effectuée sur l'échantillon.

2. Procédé selon la revendication 1, **caractérisé en ce que**, lorsque la couche arrière (1) comporte une première strate (10), située à l'arrière du premier module photovoltaïque (M_1) et réalisée à base d'un polymère fluoré, le procédé consiste à fixer les paramètres d'usinage pour retirer par usinage cette première strate (10) uniquement.

3. Procédé selon la revendication 2, **caractérisé en ce que** lorsque la couche arrière (1) du premier module photovoltaïque (M_1) comporte une deuxième strate (11) située entre ladite première strate (10) et la couche intermédiaire, ladite deuxième strate (11) étant réalisée à base d'un polymère non fluoré, le procédé consiste à fixer les paramètres d'usinage pour retirer uniquement cette deuxième strate (11) par usinage, après le retrait par usinage de ladite première strate (10).

4. Procédé selon la revendication 1, **caractérisé en ce que**, lorsque la couche arrière comporte une première strate (11), située à l'arrière du premier module photovoltaïque (M_1) et réalisée à base d'un polymère non fluoré, le procédé consiste à fixer les paramètres d'usinage pour retirer cette première strate (11) uniquement par usinage.

5. Procédé selon l'une des revendications 2 à 4, **caractérisé en ce qu'**il comporte une étape d'usinage (E4) de chaque strate de la couche arrière de chaque module photovoltaïque (M_2) de la série de modules photovoltaïques selon les paramètres d'usinage (P_U) déterminés.

6. Procédé selon la revendication 5, **caractérisé en ce que** l'étape d'usinage (E4) de chaque strate est mise en œuvre par ponçage.

7. Procédé selon la revendication 5 ou 6, **caractérisé en ce qu'**il comporte une étape de vérification (E6) du retrait de ladite première strate (10) de la couche arrière.

8. Procédé selon l'une des revendications 1 à 7, **caractérisé en ce que** l'étape de découpe consiste à prélever un échantillon (ECH_2) du premier module photovoltaïque (M_1) contenant la couche arrière (1) et la couche intermédiaire (2) du premier module photovoltaïque (M_1).

9. Procédé selon la revendication 8, **caractérisé en ce que** :
- L'étape d'analyse (E2) dudit échantillon découpé est réalisée en vue de déterminer également l'épaisseur et la composition de chaque strate de ladite couche intermédiaire (2),
- Les paramètres d'usinage (P_U) sont également déterminés pour retirer chaque strate de la couche intermédiaire (2) de chaque module photovoltaïque (M_2) de la série de modules photovoltaïques en tenant compte de l'analyse effectuée sur l'échantillon.

10. Procédé selon la revendication 9, **caractérisé en ce qu'**il comporte une étape d'usinage de la couche intermédiaire de chaque module photovoltaïque (M_2) de la série modules photovoltaïques en tenant compte des paramètres d'usinage déterminés.

11. Procédé selon la revendication 10, **caractérisé en ce qu'**il comporte une étape de vérification du retrait de la couche intermédiaire.

12. Procédé selon l'une des revendications 1 à 11, **caractérisé en ce que** l'étape d'analyse (E2) est réalisée par spectroscopie infrarouge à transformée de Fourier.

13. Procédé selon l'une des revendications 1 à 12, **caractérisé en ce que** l'étape de découpe (E1) est mise en œuvre à l'aide d'un outil de découpe (4) contrôlé pour venir découper le premier module photovoltaïque (M_1) selon un angle déterminé, incliné par rapport à la normale au plan formé par la face arrière du premier module photovoltaïque.

14. Système de démantèlement d'une série de modules photovoltaïques (M_1, M_2), chaque module photovoltaïque de la série de modules photovoltaïques comprenant plusieurs couches superposées composées de :
- Une première couche, dite couche arrière (1), formant un premier élément de protection en face arrière du module photovoltaïque (M_1), cette couche arrière étant réalisée à base d'au moins un matériau polymère,
- Une deuxième couche, dite couche intermédiaire (2), intercalée entre la couche arrière (1) et une troisième couche, dite couche avant (3), et comprenant une enveloppe d'encapsulation (21) dans laquelle sont placées des cellules photovoltaïques (20),
- La couche avant (3), formant un deuxième élément de protection en face avant du module photovoltaïque (M_1),
- Chaque couche pouvant comporter une ou plusieurs strates,
- **Caractérisé en ce que** le système comporte :
- Un poste de découpe (P1) d'un échantillon (ECH_1) d'un premier module photovoltaïque (M_1) de la série, ledit échantillon comportant au moins ladite couche arrière du module photovoltaïque,
- Un poste d'analyse (P2) dudit échantillon découpé en vue de déterminer l'épaisseur et la composition de chaque strate de ladite couche arrière,
- Des moyens de détermination de paramètres d'usinage (P_U) à appliquer pour retirer chaque strate de la couche arrière (1) de chaque module photovoltaïque de la série de modules photovoltaïques en tenant compte de l'analyse effectuée sur l'échantillon par le poste d'analyse (P2).

15. Système selon la revendication 14, **caractérisé en ce que**, lorsque la couche arrière (1) comporte une première strate (10), située à l'arrière du premier module photovoltaïque (M_1) et réalisée à base d'un polymère fluoré, les moyens de détermination sont configurés pour fixer les paramètres d'usinage pour retirer par usinage cette première strate (10) uniquement.

16. Système selon la revendication 15, **caractérisé en ce que** lorsque la couche arrière (1) du premier module photovoltaïque (M_1) comporte une deuxième strate (11) située entre ladite première strate (10) et la couche intermédiaire, ladite deuxième strate (11) étant réalisée à base d'un polymère non fluoré, les moyens de détermination sont configurés pour fixer les paramètres d'usinage pour retirer uniquement cette deuxième strate (11) par usinage, après le retrait par usinage de ladite première strate (10).

17. Système selon la revendication 14, **caractérisé en ce que**, lorsque la couche arrière comporte une première strate (11), située à l'arrière du premier module photovoltaïque (M_1) et réalisée à base d'un polymère non fluoré, les moyens de détermination sont configurés pour fixer les paramètres d'usinage pour retirer cette première strate (11) uniquement par usinage.

18. Système selon l'une des revendications 15 à 17, **caractérisé en ce qu'**il comporte un poste d'usinage (P3, P4) distinct pour usiner chaque strate de la couche arrière de chaque module photovoltaïque (M_2) de la série de modules photovoltaïques selon les paramètres d'usinage (P_U) déterminés pour le premier module photovoltaïque (M1).

19. Système selon la revendication 18, **caractérisé en ce que** chaque poste d'usinage (P3, P4) comporte un outil de ponçage.

20. Système selon l'une des revendications 14 à 19, **caractérisé en ce que** le poste de découpe est contrôlé pour prélever un échantillon (ECH_2) du premier module photovoltaïque (M_1) contenant la couche arrière (1) et la couche intermédiaire (2) du premier module photovoltaïque (M_1).

21. Système selon la revendication 20, **caractérisé en ce que** :
- Le poste d'analyse (P2) dudit échantillon découpé est configuré pour déterminer également l'épaisseur et la composition de chaque strate de ladite couche intermédiaire (2),
- Les paramètres d'usinage (P_U) sont également déterminés pour retirer chaque strate de la couche intermédiaire (2) de chaque module photovoltaïque (M_2) de la série de modules photovoltaïques en tenant compte de l'analyse effectuée sur l'échantillon par le poste d'analyse (P2).

22. Système selon la revendication 21, **caractérisé en ce qu'**il comporte un poste d'usinage de la couche intermédiaire de chaque module photovoltaïque (M_2) de la série modules photovoltaïques en tenant compte des paramètres d'usinage déterminés.

23. Procédé selon l'une des revendications 14 à 22, **caractérisé en ce que** le poste d'analyse (P2) comporte un spectroscope infrarouge à transformée de Fourier.

24. Système selon l'une des revendications 14 à 23, **caractérisé en ce que** l'outil de découpe (4) est contrôlé pour venir découper le premier module photovoltaïque (M_1) selon un angle déterminé, incliné par rapport à la normale au plan formé par la face arrière du premier module photovoltaïque.
